# EUROPEAN PATENT APPLICATION

(11) **EP 3 480 336 A1**
(43) Date of publication of application: **08.05.2019**
(21) Application number: 17200363.4
(22) Date of filing: 07.11.2017
(51) Int. Cl.: C23C 14/24, B24B 13/005, C23C 14/50

(54) **OPTICAL ELEMENTS HOLDER DEVICE FOR A COATING STATION**

(71) Applicant: Satisloh AG, 6340 Baar (CH)
(72) Inventor: BONGIORNO, Gero Antonio, 20080 CISLIANO (IT); CONGIA, Fabio, 20021 BOLLATE (IT); COLAUTTI, Arturo, 20157 MILANO (IT)
(74) Representative: Croonenbroek, Thomas Jakob

(57) **Abstract**

The invention relates to an optical elements holder device for a coating station comprising
- a sheet carrier (21) having holes (23) and presenting the shape of a dome or a part of a dome,
- elastic blocking means (24) fixed to the sheet carrier (21) associated to each hole (23),
wherein the elastic blocking means (24) comprise at least three elastic contact portions distributed on the circumference of the hole (23) and configured to block a block piece (B) carrying a lens blank (SFB) in order that the lens blank (SFB) may be hold in a predetermined position for coating.

## Description

### FIELD OF THE INVENTION

The invention relates to an optical elements holder device for a coating station configured in particular for carrying out a coating, specifically an AR (anti-reflective coating) on an optical element within a vacuum chamber.

### BACKGROUND AND PRIOR ART

Generally, most of nowadays manufactured spectacle lenses have an anti-reflective coating on both sides of their faces which provide to users an enhanced visual comfort, less fatigue and beautify the appearance of the user. In addition, anti-reflective coating increases the contrast resulting in a better sight of the user in particular when car driving.

Such anti-reflective coating is generally carried out in a coating station known in the state of the art as "box coater".

The execution of such an antireflection treatment involves subjecting optical elements or ophthalmic lens blanks to deposition of a stack of dielectrics under vacuum in an enclosure or chamber suitable for this purpose.

To do this, the optical elements are arranged in a group on a collective support which, for practical reasons, is generally in the form of sectors forming a spherical cap or dome which constitutes part of a conventional turntable.

The optical elements are lying in holding rings or are clamped in clamping rings with one side facing toward a vaporization source or sputter source. The rings / optical element holders are usually placed in the cutouts of metal sheet carriers which are mounted above the vaporization source so as to assume the form of a spherical dome and are rotated about the axis of symmetry of the spherical dome by means of a rotation device. The metal sheet carrier may form segments of the spherical dome or the spherical dome itself.

EP 0 497 651 discloses an example of such a collective support which comprises substrate holders in form of sectors forming the spherical dome. The substrate holders present circular holes. The optical elements to be treated are fastened on an individual support which then is inserted in the circular hole.

Although this solution is well working, it is quite man work intensive because the optical elements must be put and fixed manually on the individual support and then be inserted manually in the circular holes of the substrate holders before the treatment and retrieved manually after the treatment.

An additional difficulty in the manual mounting of the optical elements resides in the fact that the operator needs to be very concentrated and focused on his work in order to insert or retrieve the optical elements in the right locations. Indeed, in order to manufacture spectacles lenses according to a prescription, every optical element has specific properties, in particular in curvature and shape, and the operator needs to put for example the treated optical elements in the assigned transportation boxes with respect to the prescription of the user's spectacle lenses.

US20160024643 discloses another example of coating station for application of an anti-reflective coating.

US20090206535 discloses a rotatable lens holder with a box coater allowing automatic turning of the optical elements to be treated. This allows application of an antireflective coating to both sides of the lens blank without the need to ventilate the vacuum chamber for manually turning the optical elements to be treated. However, the optical elements need to be fixed manually on a lens holder having tangential clamping springs. This operation is quite delicate, difficult to automate and the edges of the optical elements might be damaged.

US20120186522 discloses another solution of a coating station where the holes in the substrate holder have four fingertip recesses, one on the recesses presenting a leaf spring with a pressing portion.

In the vapor deposition apparatus of US20120186522, the optical lenses are mounted in the lens holes of each lens holding body. In mounting an optical lens, the elastically deformable portion of the leaf spring is elastically deformed backwards to retract the pressing portion from the lens hole into the mounting portion. An operator holds the outer peripheral surface of the optical lens between his or her two fingers, and inserts these fingers into the recesses, thereby inserting the optical lens into the lens hole.

The elastically deformable portion of the leaf spring is then released and the pressing portion presses the edge of the optical lens in a point pattern to firmly hold the lens.

In this solution, automation is also quite very difficult and the risk of the lenses to be damaged during mounting and retrieval is quite high. Furthermore, because of the tiny space for manipulation, the risk that the operator touches one of the faces of the optical element to be treated is quite high which might then cause trouble to the anti-reflective treatment to be applied.

Furthermore, US20120186522 discloses one leaf spring for each hole. Due to the mounting of the lenses and the need of the fingertip recesses, it is not possible to add a further leaf spring to each hole. The inserted lenses are not centered with regard to the holes of the lens holding body.

Another aspect to be taken into account relates to back-deposition phenomenon, meaning if there are openings remaining once the optical element has been mounted in a hole of the dome, deposition material may be travelling through these openings around the optical element and be deposited on the back side of the optical element.

The present invention proposes an improved substrate holder for a coating station of optical elements which is more robust with respect to manipulation of the optical elements to be treated and eases possible automation.

To this extent, the present invention proposes an optical elements holder device for a coating station comprising
- a sheet carrier having holes and presenting the shape of a dome or a part of a dome,
- elastic blocking means fixed to the sheet carrier associated to each hole,
   wherein the elastic blocking means comprise at least three elastic contact portions distributed on the circumference of the hole and configured to block a block piece carrying a lens blank in order that the lens blank may be hold in a predetermined position for coating.

Thanks to the optical elements holder device according to the invention, a simple picking and positioning movement of an operator or a robot allows mounting the optical elements to be coated on the optical elements holder device in a centered manner.

The optical elements holder device according to the invention may comprise one or several of the following features taken alone or in combination:

According to one aspect, the elastic contact portions are regular distributed on the circumference of the hole.

The elastic contact portion may be made of elastic material.

According to one possible embodiment, the elastic blocking means comprises an O-ring made of elastic material, for example made of fluoroelastomer.

According to a further aspect, the O-ring may be housed in an annular ring housing of the optical element holder device, the annular ring housing being arranged in a hole.

The annular ring housing can be welded to the sheet carrier.

The annular ring housing can also be detachably fixed to the sheet carrier, for example by clipping fastening means for clipping the annular ring housing into a hole of the sheet carrier.

To this extent, the annular ring housing may present bayonet fitting means for fixing the annular ring housing into a hole of the sheet carrier.

According to a further aspect, the annular ring housing can present an alignment element, in particular an alignment bar configured to cooperate the backside of the block piece, in particular with a transverse central groove on the backside of the block piece.

According to another embodiment, the elastic blocking means comprises for example a metallic cylinder welded in a centered position with respect to an associated hole, to the sheet carrier and presenting at least three, elastic inwardly bent cutouts tongues for cooperation with the backside of the block piece and fixing the latter in a centered position with respect to the associated hole.

In this case, the metallic cylinder may also present an alignment element, in particular an alignment bar configured to cooperate with the backside of the block piece, in particular with a transverse central groove on the backside of the block piece.

The present invention also relates to a coating station for optical elements, comprising at least one optical elements holder device with the above cited features.

The invention further relates to a method for coating an optical element in a coating station as cited above comprising the following steps :
- picking up a block piece carrying a lens blank having a face to be coated,
- inserting the block piece into a hole of the sheet carrier thereby automatically blocking the block piece in a removable way in a centered position in order that the lens blank may be hold in a predetermined position for coating,
- coat the lens blank,
- extract the block piece from the hole of the sheet carrier.

According to one aspect, the steps of picking up, inserting and extracting of the block piece are carried out by a robot.

### BRIEF DESCRIPTIONS OF THE DRAWINGS

Other advantages and characteristics will appear with the reading of the description of the following figures:
- Figure 1 is a schematic view in cross-section of an optical element fixed on a block piece,
- Figure 2 is a schematic cross section of a coating station according to the invention,
- Figure 3 is a schematic view in perspective of an optical elements holder device according to the invention,
- Figure 4 is a schematic view in cross section of a part of a sheet carrier and an optical element fixed on a block piece shown according to a first embodiment of the invention,
- Figure 5 is a another schematic view in cross section of a part of the sheet carrier according to the first embodiment,
- Figure 6 is a schematic view in perspective of a part of the sheet carrier according to the first embodiment and an elastic blocking means,
- Figure 7 is a schematic view in perspective of a part of the sheet carrier of an optical elements holder device according to a second embodiment,
- Figure 8 is a schematic view in perspective of a part of the sheet carrier of an optical elements holder device according to a third embodiment,
- Figure 9 is a schematic view in perspective of a part of the sheet carrier of an optical elements holder device according to a fourth embodiment,
- Figure 10 is a schematic view in perspective of a side receiving the block piece with the optical element fixed thereon and of a part of the sheet carrier according to the fourth embodiment,
- Figure 11 is a schematic view in cross section of a part of the sheet carrier according to the fourth embodiment, with a block piece received into a hole of the sheet carrier,
- Figure 12 is a schematic view in perspective of Figure 11,
- Figure 13 is a larger schematic view in perspective of an example of a sheet carrier of the optical elements holder device according to the fourth embodiment receiving a block piece with an optical element mounted thereon,
- Figure 14 is a schematic view in perspective of an elastic blocking means to be fixed to the sheet carrier of an optical elements holder device according to a fifth embodiment,
- Figure 15 is a schematic view of the elastic blocking means of figure 14 cooperating with the backside of a block piece.

### DETAILED DESCRIPTION

The embodiment(s) in the following description are only to be considered as examples. Although the description refers to one or several embodiments, this does not mean inevitably that every reference concerns the same embodiment, or that the characteristics apply only to a single embodiment. Simple characteristics of various embodiments can be also combined to new embodiments that are not explicitly described.

In the present description, the terms "upstream" and "downstream" are used according the following meaning : a first station for a certain processing operation of an optical element is placed upstream with respect to a second station when the optical element undergoes first the operation in the first station and then another operation in the second station.

And a first station for processing a certain processing operation of an optical element is placed downstream with respect to a second station when the optical element undergoes first the operation in the second station and then another operation in the first station.

In the figures is shown a reference triad X-Y-Z, where X and Y are two horizontal axes perpendicular to each other and Z is a vertical axis perpendicular to X and Y.

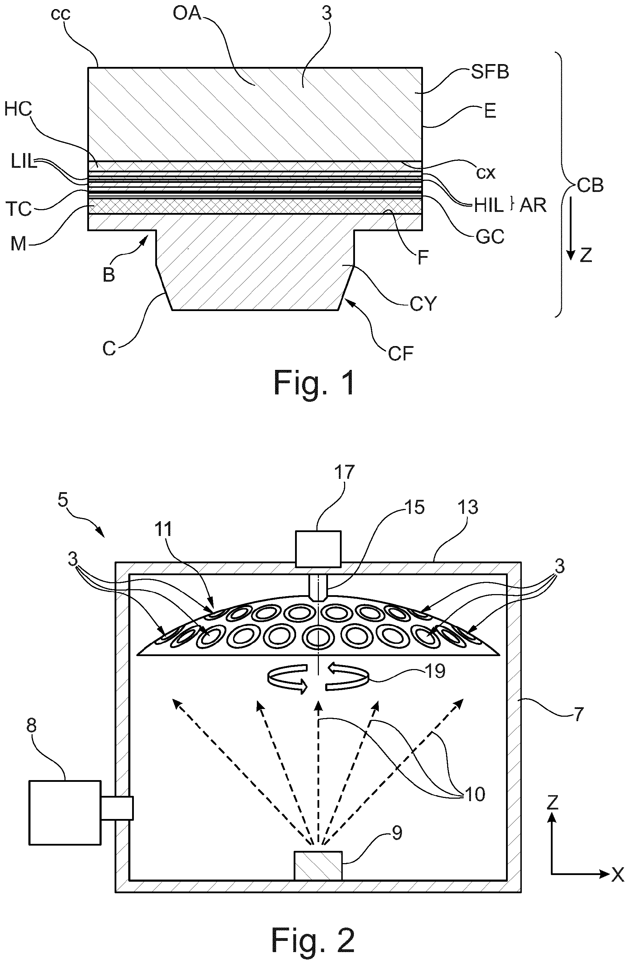

In figure 1 is shown an optical element 3 which is for example a lens blank, in particular a semi-finished lens blank SFB which is fixed to a block piece B.

A semi- finished lens blank SFB comprises for example a first face cx, a second face cc opposite said first face cx, and an edge E between the first face cx and the second face cc.

The first face cx possesses a final curvature (not shown in the drawing) and is already coated, starting from a substrate comprised of, e.g., mineral glass, polycarbonate, PMMA, CR 39, Trivex<®>, HI index, etc., as the case may be, with a standard hard coating HC, a standard antireflection coating AR on top of the hard coating HC, a standard top coating TC on top of the antireflection coating AR, and a special temporary grip coating GC on top of the top coating TC.

As is known per se, the antireflection coating AR comprises for example a stack of alternating antireflection layers of high index HIL and low index LIL with an outermost, in Fig. 1 lowest layer. The top coating TC is selected from a group comprising hydrophobic, oleophobic and dirt repelling coatings, as known.

The thickness of the temporary grip coating GC may range from 1 to 500 nm, preferably from 5 to 100 nm, and more preferably from 10 to 20 nm, in particular 15nm.

Further, in Fig. 1 reference sign CB designates a combination of the above semi-finished lens blank SFB and a block piece B for holding the semi-finished lens blank SFB for processing thereof, in particular for coating process in a coating station 5 (see figure 2).

As to the structure and function of a currently preferred block piece B explicit reference is being made at this point to document EP 2 093 018 A1 of the present applicant.

Such block piece B, which can be used in thin film coating processes under vacuum conditions, typically has a basic body made from a plastic material, with a workpiece mounting face F for attachment of the lens blank SFB with the aid of a blocking material M on one side, and a clamping portion C on the other side which is configured to be grasped by an elastic blocking means (detailed later on in the description) during coating. Clamping portion C has a cylindrical portion CY and a frustoconical shape (truncated cone) CF.

Generally speaking, during lens processing, the lens blank SFB is blocked on the basic body of the block piece B in a machine or apparatus for processing of the lens blank SFB, and to provide in particular for reliable and secure mounting to the processing equipment throughout the whole process while avoiding damage and/or deformation to the lens blank SFB.

As far as a presently preferred blocking material M is concerned, which is applied directly onto the temporary grip coating GC of the lens blank SFB and preferably comprises an adhesive curable by UV or visible light that is liquid in an un-polymerized state, explicit reference is being made at this point to document EP 2 011 604 A1 of the present applicant. In order to enhance the bonding effect, the workpiece mounting face F of the block piece B may be plasma treated prior to applying the blocking material M onto the workpiece mounting face F.

During manufacturing of spectacle lenses, the second face cc of the semi-finished lens blank SFB needs to be coated in the coating station 5 as shown in figure 2.

However, in alternative embodiments, one may consider that face cc possesses a final curvature and is already coated. In this case the semi-finished lens blank SFB is fixed and blocked with its face cc on the block piece B and the cx face shall receive an AR coating.

Figure 2 shows a cross sectional view of an example of a coating station 5 for application in particular of an AR coating to the face cc of the semi-finished lens blank SFB.

In a manufacturing process of spectacle lenses, the coating station 5 is generally disposed downstream a lens surfacing station (not shown) which gives a desired surface contour to face cc and downstream one or more cleaning stations and an hard coating station needed to prepare the surfaced face cc of the semi-finished lens blank SFB for coating under vacuum.

By "lens surfacing", it is understood in particular polishing, grinding or fine grinding and the overall object is to yield a finished spectacle lens so that the curvature of the first (in this instance convex) face cx and the curvature of the machined second (in this instance concave) face cc cooperate to yield desired optical properties according to a prescription of the user of the spectacle lenses.

The coating station 5 comprises a vacuum chamber 7 that is connected to a vacuum pump system 8. On the bottom of the vacuum chamber 7 is disposed a vaporization source 9.

During coating, a not shown vaporization material is heated, for example by an electric heating device or an electron beam source in order to vaporize or sublimate the vaporization material (schematically shown by arrows 10) that will be deposited on the optical elements 3, in particular the face cc of the semi-finished lens blank SFB.

The coating station 5 further comprises an optical elements holder device 11 which is hanging from the top wall 13 of the vacuum chamber 7 and is connected, through a rotation axis 15, to a drive motor 17 configured to rotate (arrows 19) the optical elements holder device 11.

Rotation of the optical elements holder device 11 during coating ensures averaging spatial inhomogeneity of the vaporization cone during coating.

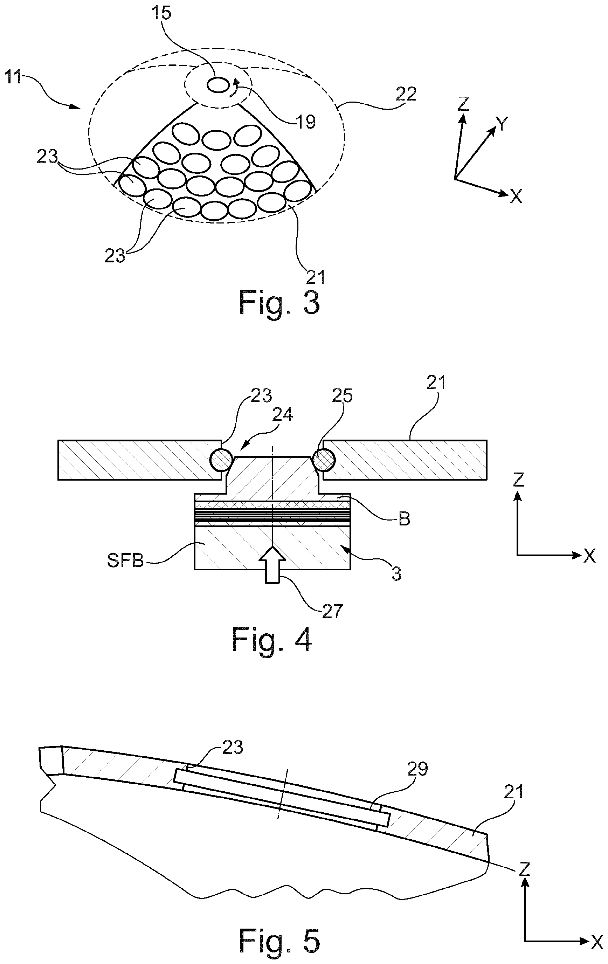

As can be seen on figure 3, the optical elements holder device 11 comprises one or several sheet carrier(s) 21 for example metal sheet carrier(s) having a plurality of holes 23, such as circular holes, and presenting the shape of a dome or a part of a dome in order to put all optical elements 3 to the same distance with respect to the vaporization source 9.

In figure 3 is shown in dotted lines a dome frame 22 configured to support four different sheet carriers 21, only one them having holes 23.

As can be seen on figure 4, the optical elements 3 are mounted in a releasable manner upside down in the optical elements holder device 11. Thus in figure 2, one can see the backside of the block piece B, the semi-finished lens blank SFB pointing in direction towards the vaporization source 9.

In order to allow easy mounting of the optical elements 3 blocked on the block piece B, an elastic blocking means 24 associated to each hole 23 is fixed to the sheet carrier 21.

This can be seen more in detail in figure 4 which is a schematic view in cross section of a part of a sheet carrier 21 and an optical element 3 fixed on a block piece B of a first embodiment according to the invention.

According to this embodiment, the elastic blocking means 24 comprises an O-ring 25 of elastic material, like i.e. a fluoroelastomer like VITON (registered trademark) by the company DuPont.

A fluoroelastomer as elastic material has the advantage to withstand the vacuum conditions during coating and not to contaminate the coating process.

In order to mount the optical element 3 with its associated block piece B into a hole 23, one only has to grasp or to picking up the block piece B on its lateral sides and to insert it by pushing along arrow 27 into the hole 23. The movement to insert the block piece B into the hole 23 is quite simple so that it may be carried out by a robot programmed to realize the mounting instead of a human operator.

As the internal diameter of the O-ring 25 is slightly smaller than the largest diameter of the clamping portion C, the O-ring 25 will be radially compressed and will hold the block piece B by friction regularly contacting the block piece B on all the circumference of the hole 23. The O-ring 25 will then clamp the block piece B in a releasable manner and block the block piece B in a centered position such that the semi-finished lens blank SFB is hold in a predetermined position for coating.

As can be seen in figures 4 and 5, the thickness of the sheet carrier 21 is large enough to allow creation of an inner circumferential groove 29 in the wall of the hole 23 receiving the O-ring 25.

According to one aspect, the O-ring 25 may be hold only through mechanical clamping though the form of the inner circumferential groove 29. This allows changing the O-ring 25 when worn for example.

According to another aspect, the O-ring 25 may be bond through adapted glue to the sheet carrier 21.

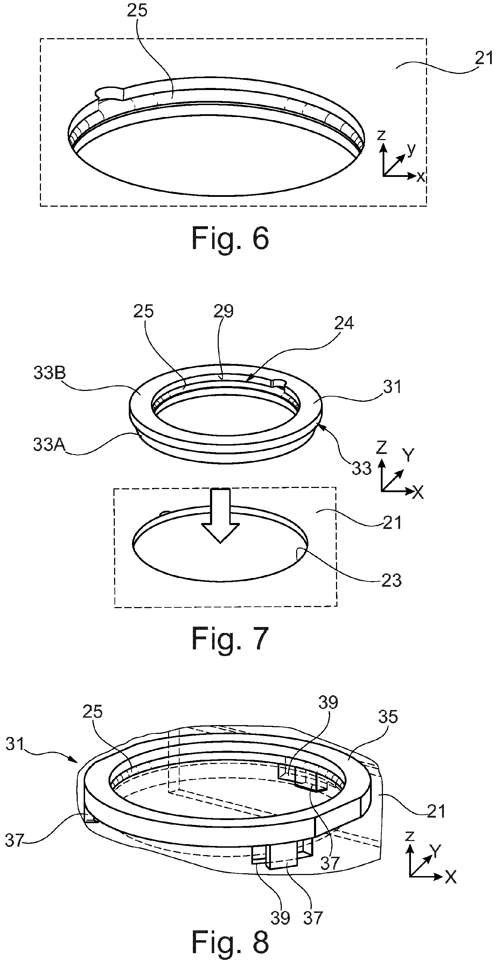

A mounted O-ring 25 is shown in figure 6.

In this first embodiment, the O-ring 25 will be in contact over its entire internal diameter with the block piece B, more specifically with the entire cylindrical portion CY of the clamping portion C. Therefore the O-ring 25 has infinity of elastic contact portions in contact with the clamping portion C of the block piece B to block the latter in a centered position in order that the semi-finished lens blank SFB may be hold in a predetermined position for coating.

According to a not shown alternative, the O-ring may be replaced by, for example three, four or five elastic protuberances fixed to the inside of the hole 23, protruding towards the center of the latter one, and in particular regularly distributed on the circumference of the hole 23. Each elastic protuberance forms an elastic contact portion with the block piece B when the latter is inserted into the hole 23. Thus the elastic contact portion is made of an elastic material.

By regularly distributed, it is meant that the angular distance between the protuberances is equal. In case of three protuberances, the angular distance between the center of the protuberance is 120°, in case of four 90° etc.

In a specific variant, for example for three protuberances, the latter are not regularly distributed, but for example according to a "Y" configuration.

According to a second embodiment shown in figure 7, the O-ring 25 is housed in a separate annular ring housing 31 of the optical elements holder device 11, the annular ring housing 31 being arranged in a hole 23.

The annular ring housing 31 has for example a stepped outer side wall 33 formed by a first ring portion 33A having a smaller diameter than the one of the hole 23 and a second ring portion 33B having a larger diameter than the one of the hole 23. As in the previous embodiment, the annular ring housing 31 presents an inner circumferential groove 29 receiving the O-ring 25.

For fixing the annular ring housing 31 in the hole 23, one may consider the possibility to weld the annular ring housing 31 to the sheet carrier 21, in particular when made of metal.

The third embodiment shown in figure 8 is similar to the second embodiment but differs in particular by the fact that the annular ring housing 31 is detachably fixed to the sheet carrier 21. For this purpose, the annular ring housing 31 is formed by a cover ring 35 comprising for example bayonet fitting means, such as three axial fixing lugs 37 that cooperate via bayonet coupling with correspondent recesses 39 (or cutouts) of the hole 23 of the sheet carrier 21.

In this embodiment, the cover ring 35 also compresses the O-ring 25 along a direction perpendicular to the sheet carrier 21. This contributes to fix the annular ring housing 31 to the sheet carrier 21.

According to a not shown alternative to this third embodiment, the annular ring housing 31 presents clipping fastening means for clipping the annular ring housing 31 into the hole 23 of the metal carrier sheet 21. This may be realized for example by particular axial fixing lugs 37 of a cover ring 35 that not rotate. Those axial fixing lugs 37 are elastic and present an insertion ramp at their tips. They can snap outwardly when inserted axially into the recesses 39 of the hole 23.

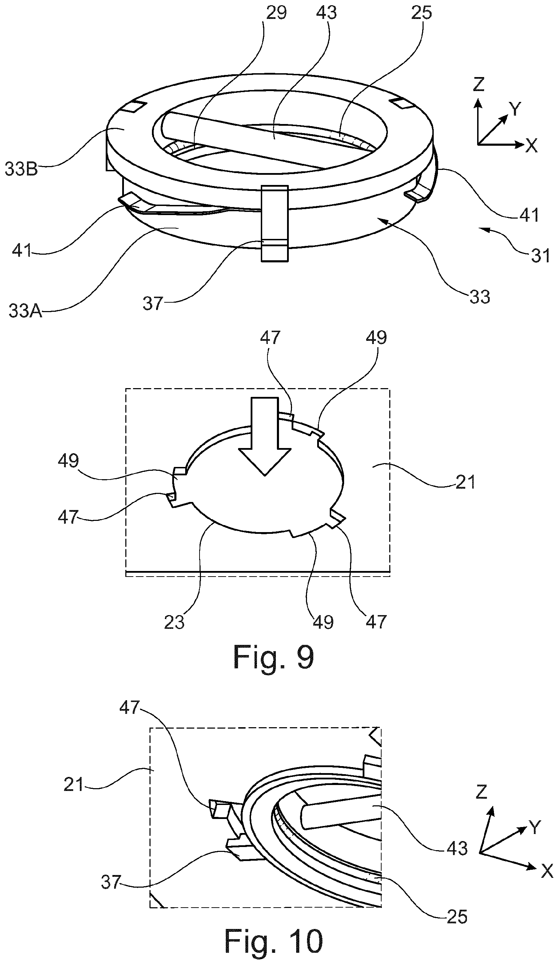

Figure 9 relates to a fourth embodiment having some similarities with both the second embodiment shown in figure 7 and the third embodiment shown in figure 8.

Indeed, the fourth embodiment is similar to the second embodiment because the O-ring 25 is housed in a separate annular ring housing 31, having a stepped outer side wall 33 formed by a first ring portion 33A having a smaller diameter than the one of the hole 23 and a second ring portion 33B having a larger diameter than the one of the hole 23. As in the previous embodiment, the annular ring housing 31 presents, in the first ring portion 33A, an inner circumferential groove 29 receiving the O-ring 25.

Similar to the third embodiment, the annular ring housing 31 presents three axial fixing lugs 37 (only one of them is visible in figure 9).

Furthermore, the outer skirt of the first ring portion 33A presents three ramps 41 (only two are visible in figure 9) disposed between the axial fixing lugs 37 and configured to cooperate with the border of the hole 23. The ramps 41 may be realized by a sheet metal strip welded to the outer skirt of the first ring portion 33A, or may be realized by machining or milling operations or additive production methods.

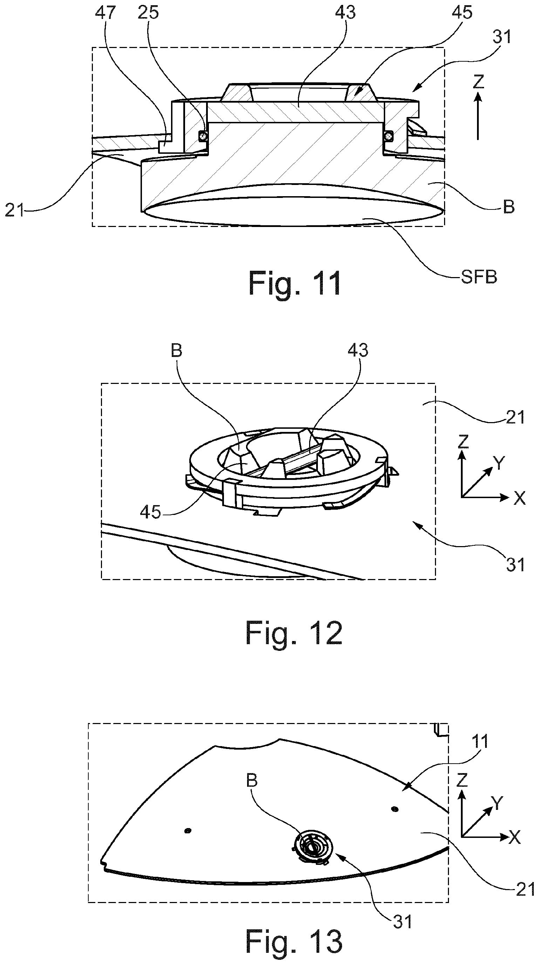

According to another aspect, the annular ring housing 31 comprises an alignment element like for example an alignment bar 43 configured to cooperate with the backside of the block piece B in particular with a transverse central groove 45 (figures 11 and 12) on the backside of the block piece B. As shown later on, this alignment bar 43 serves as a stop during insertion of the block piece B and allows fixing the angular position of the block piece B in the hole 23. It is understood that also other alignment elements supported by the annular ring housing 31 may be foreseen like a protrusion pointing for example in direction of the center axis of the annular housing 31.The basic principle behind is to get a well-defined mounting of the block piece B into the annular ring housing 31 according to the Poka Yoke principle.

For cooperation with this annular ring housing 31, the hole 23 of the sheet carrier 21 has three notches 47 for inserting the axial fixing lugs 37 and three peripheral cutouts 49, each in connection to a notch 47, for insertion of the ramps 41.

For releasable mounting the annular ring housing 31 on the sheet carrier 21, an axial insertion movement inserting the axial fixing lugs 37 in the correspondent notches 47 followed by a rotation like a screw movement has to be operated.

Figure 10 shows the annular ring housing 31 of figure 9 mounted in a hole 23 of a sheet carrier 21. The axial fixing lugs 37 cooperate with the underside of the sheet carrier 21 which faces the vaporization source 9.

Figures 11 to 13 show respectively in a cross sectional view and two views in perspective the annular ring housing 31 of figure 9 and 10 mounted in a hole 23 of a sheet carrier 21 and a block piece B supporting a semi-finished lens blank SFB inserted into the annular ring housing 31. These figures also show the alignment bar 43 as alignment element cooperating with the backside of the block piece B for angular orientation within the hole 23 and for acting as a stopper.

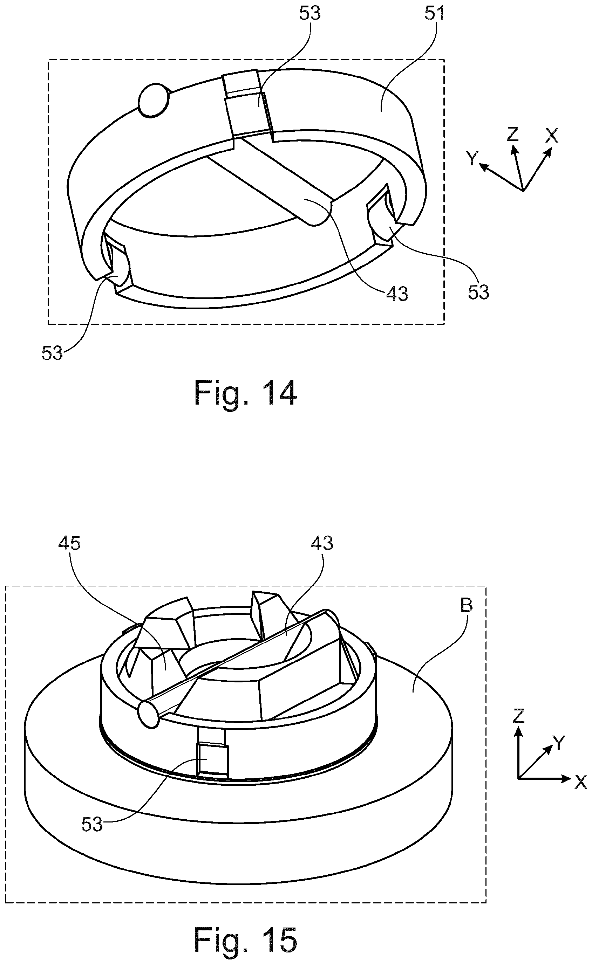

Figures 14 and 15 show a fifth embodiment where the elastic blocking means 24 comprises a metallic cylinder 51 and presenting at least three, regularly distributed elastic inwardly bent cutouts tongues 53 for cooperation with the backside of the block piece B and fixing the latter in a centered position with respect to the associated hole 23 of the sheet carrier 21.

The metallic cylinder 51 furthermore presents an alignment bar 43 similar to that of other embodiments described above and configured to cooperate with a transverse central groove 45 on the backside of the block piece B.

The metallic cylinder 51 is for example welded in a centered position with respect to an associated hole 23, to the sheet carrier 21 on the side of the latter opposing the vaporization source 9.

In inserting the block piece B into the metallic cylinder 51, elastic inwardly bent cutouts tongues 53 form three elastic contact portions which are i.e. regularly distributed on the circumference of the hole 23 and configured to block in a centered position the block piece B. The elastic inwardly bent cutouts tongues 53 will press against the clamping portion C, in particular cylindrical portion CY, of the block piece B and fix thus the optical element 3 in position, ready for a coating process. This embodiment is also quite simple in construction because the tongues are functioning as a spring to contact and to press the block piece B and they do not need further / other elastic means.

The present invention also relates to a method for coating an optical element 3 in a coating station 5 as described above and comprising the following steps :
- picking up a block piece B carrying a lens blank, in particular a semi-finished lens blank SFB having a face cc to be coated,
- inserting the block piece B into a hole 23 of the sheet carrier 21 thereby automatically blocking the block piece B in a removable way for example in a centered position in order that the lens blank SFB may be hold in a predetermined position for coating,
- coat the lens blank SFB,
- extract the block piece B from the hole 23 of the sheet carrier 21.

The steps of picking up, inserting and extracting the block piece B may be carried out manually or preferentially by a not shown robot.

As already mentioned above, face cc and cx may be inverted in the sense that face cx needs to be coated and not face cc of the semi-finished lens blank SFB.

One can understand easily that the optical elements holder device 11 according to the invention eases the manipulation of the semi-finished lens blanks SFB and even allows robotizing of the coating method.

In addition, in particular with regard to the embodiments shown on the figures, back-deposition on the clamping portion C of block piece B is avoided, allowing therefore multiple re-use of the block piece B.

### List of references:

- SFB: - Semi-finished lens blank
- B: - Block piece
- Cx: - First face (i.g. convex)
- Cc: - Second face (i.g. concave)
- E: - Edge
- HC: - Hard coating
- AR: - Anti-reflection coating
- TC: - Top coating
- GC: - Grip coating
- HIL: - High index anti-reflection layer
- LIL: - Low index anti-reflection layer
- CB: - Combination of SFB and B
- M: - Blocking material
- C: - Clamping portion
- CY: - Cylindrical portion of the clamping portion
- CF: - Frustoconical portion of the clamping portion
- F: - Workpiece mounting face
- A: - Rotation axis
- OA: - Optical axis

- 3: - Optical element
- 5: - Coating station
- 7: - Vacuum chamber
- 8: - Vacuum pump system
- 9: - Vaporization source
- 10: - Arrow
- 11: - Optical elements holder device
- 13: - Top wall
- 15: - Rotation axis
- 17: - Drive motor
- 19: - Arrows
- 21: - Sheet carrier
- 22: - Dome frame
- 23: - Holes
- 24: - Elastic blocking means
- 25: - O-ring
- 27: - Arrow
- 29: - Circumferential groove
- 31: - Annular ring housing
- 33: - Outer side wall
- 33A: - First ring portion
- 33B: - Second ring portion
- 35: - Cover ring
- 37: - Axial fixing lugs
- 39: - Recesses
- 41: - Ramps
- 43: - Alignment bar
- 45: - Transverse central groove
- 47: - Notches
- 49: - Peripheral cutouts
- 51: - Metallic cylinder
- 53: - Elastic inwardly bent cutout tongues

## Claims

1. Optical elements holder device (11) for a coating station (5) comprising
- a sheet carrier (21) having holes (23) and presenting the shape of a dome or a part of a dome,
- elastic blocking means (24) fixed to the sheet carrier (21) associated to each hole (23),
wherein the elastic blocking means (24) comprise at least three elastic contact portions distributed on the circumference of the hole (23) and configured to block a block piece (B) carrying a lens blank (SFB) in order that the lens blank (SFB) may be hold in a predetermined position for coating.

2. Optical elements holder device as to claim 1, wherein the elastic contact portion are regular distributed on the circumference of the hole (23).

3. Optical elements holder device as to claim 1 or 2, wherein the elastic contact portion is made of elastic material.

4. Optical elements holder device as to any of claims 1 to 3, wherein the elastic blocking means (24) comprises an O-ring (25) made of elastic material.

5. Optical elements holder device as to claim 4, wherein the O-ring (25) is made of fluoroelastomer.

6. Optical elements holder device as to claims 5 to 6, wherein the O-ring (25) is housed in an annular ring housing (31) of the optical element holder device (11), the annular ring housing (31) being arranged in a hole (23).

7. Optical elements holder device as to claim 6, wherein the annular ring housing (31) is welded to the sheet carrier (21).

8. Optical elements holder device as to claim 6, wherein the annular ring housing (31) is detachably fixed to the sheet carrier (21).

9. Optical elements holder device as to claim 8, wherein the annular ring housing (31) presents clipping fastening means for clipping the annular ring housing (31) into a hole (23) of the sheet carrier (21).

10. Optical elements holder device as to any of claims 6 to 9, wherein the annular ring housing (31) presents an alignment element, in particular an alignment bar (43) configured to cooperate the backside of the block piece (B), in particular with a transverse central groove (45) on the backside of the block piece (B).

11. Optical elements holder device as to any of claims 1 to 3, wherein the elastic blocking means (24) comprises a metallic cylinder (51) welded in a centered position with respect to an associated hole (23), to the sheet carrier (21) and presenting at least three, elastic inwardly bent cutouts tongues (53) for cooperation with the backside of the block piece (B) and fixing the latter in a centered position with respect to the associated hole (23).

12. Optical elements holder device as to claim 11, wherein the metallic cylinder (51) presents an alignment element, in particular an alignment bar (43) configured to cooperate with the backside of the block piece (B), in particular with a transverse central groove (45) on the backside of the block piece (B).

13. Coating station (5) for optical elements, comprising at least one optical elements holder device (11) according to any of claims 1 to 12.

14. Method for coating an optical element (3) in a coating station (5) according to claim 13 comprising the following steps :
- picking up a block piece (B) carrying a lens blank (SFB) having a face (cc) to be coated,
- inserting the block piece (B) into a hole (23) of the sheet carrier (21) thereby automatically blocking the block piece (B) in a removable way in a centered position in order that the lens blank (SFB) may be hold in a predetermined position for coating,
- coat the lens blank (SFB),
- extract the block piece (B) from the hole (23) of the sheet carrier (21).

15. Method for coating an optical element as to claim 14, wherein the steps of picking up, inserting and extracting of the block piece (B) are carried out by a robot.
